# EUROPEAN PATENT SPECIFICATION

(11) **EP 0 530 096 B1**
(45) Date of publication and mention of the grant of the patent: **15.02.1995**
(21) Application number: 92402337.7
(22) Date of filing: 25.08.1992
(51) Int. Cl.: H05K 1/00, H05K 1/11, H05K 1/14, H05K 3/46, H04N 3/16

(54) **Printed circuit substrate configuration and structure**
Substratkonfiguration und Struktur für gedruckte Schaltung
Configuration et structure de substrat de circuit imprimé

(30) Priority: 29.08.1991 JP 244703/91
(43) Date of publication of application: 03.03.1993
(73) Proprietor: SONY CORPORATION, Tokyo (JP)
(72) Inventor: Sahara, Hiroshi, Shinagawa-ku, Tokyo (JP); Kusano, Susumu, Shinagawa-ku, Tokyo (JP)
(74) Representative: Thévenet, Jean-Bruno

(56) References cited:
- EP-A- 0 397 304
- GB-A- 2 165 399
- US-A- 4 545 647

## Description

### BACKGROUND OF THE INVENTION

### Field of the Invention

The present invention concerns a printed circuit substrate configuration and structure for a circuit connection substrate and, more particularly, a structure for a circuit connection substrate having connection patterns for constituting electric circuits on one side or both sides of an insulation substrate.

In the design of connection pattern of existent circuit connection substrates, terminal lands for respective devices are connected to each other by way of a line pattern, irrespective of levels of voltage and current applied to the circuit. In such a constitution, there is a risk of pattern disconnection as a result of cracking of the substrate or the like. Moreover, in a case where a large power current is supplied, there is a danger caused by arc discharge which may lead to smoke and ignition, deteriorating not only the reliability of the substrate but also the reliability of the surrounding equipment.

### OBJECT OF THE INVENTION

It is an object of the present invention to overcome the foregoing problems in the prior art and provide a structure for a printed circuit substrate having improved reliability, at the level of the substrate, even in connection structures for a circuit submitted to high supply voltages and large currents, and which is also capable of reducing line patterns in specific applications, thereby minimizing heat generation for a portion to which a large current is supplied.

### SUMMARY OF THE INVENTION

The foregoing object is attained in accordance with a first aspect of the present invention by a structure for a printed circuit substrate having a connection pattern for electric circuits and a power source on one side or both sides of an insulation substrate, wherein
a centralized land is disposed on one side of the insulation substrate, and
a power source output terminal and circuit terminals to be connected with the power source output terminal are connected on the centralized land.

A structure for a circuit connection substrate used for a horizontal deflection output circuit disposed on an insulation substrate, and capable of attaining the foregoing object can be obtained in a second aspect of the present invention wherein
a transistor, a capacitor and a diode are disposed on one side of the substrate.
a connection pattern of a power source is disposed on the other side of the substrate
a centralized land is disposed on the other side of the substrate, and
the power source output terminal, the collector terminal for a transistor, and each of the connection terminals to the capacitor, the diode and a horizontal deflection yoke are connected on the centralized land.

In the present invention, since the power source output terminal and circuit terminals to be connected with the power source output terminal are connected on the centralized land, the output terminal and the terminals for the devices in direct connection therewith, in view of the circuit, are integrally connected with the centralized land formed on the substrate.

Generally, in a case where an external force is applied to a substrate such as a printed substrate thereby causing cracking in the substrate, the probability of pattern disconnection is reduced because the area of the pattern formed is greater. Accordingly, it is desirable to connect terminal lands of a high voltage and large current circuit, having a risk of causing arc discharge upon pattern disconnection, with a pattern of large area. According to the present invention, since the terminal lands connected directly are integrated into a centralized land, they can be formed as a pattern having an area as large as possible and, as a result, the risk of causing pattern disconnection can be avoided.

### DESCRIPTION OF THE ACCOMPANYING DRAWINGS

These and other objects, as well as advantageous features of the present invention will become apparent from reading the description with reference to the accompanying drawings, wherein
Figure 1 is a view illustrating a printed circuit pattern and substrate according to the second aspect of the present invention and
Figure 2 is a circuit diagram for a horizontal deflection output circuit in the second aspect of the invention.

### DESCRIPTION OF THE PREFERRED EMBODIMENT

Description will now be made to the second aspect of the present invention with reference to the drawings but the invention is not limited only to the second aspect but also embraces the first aspect of claim 1.

In this aspect, the present invention is applied to a circuit pattern of a horizontal deflection output circuit to which high voltage and large current are supplied, and in particular, a horizontal deflection output circuit in a television receiver, such that a power output terminal land and a terminal land for each of devices in direction connection therewith are integrated into a centralized land. This connection scheme prevents pattern disconnection or the like and thus allows a highly reliable device to be obtained.

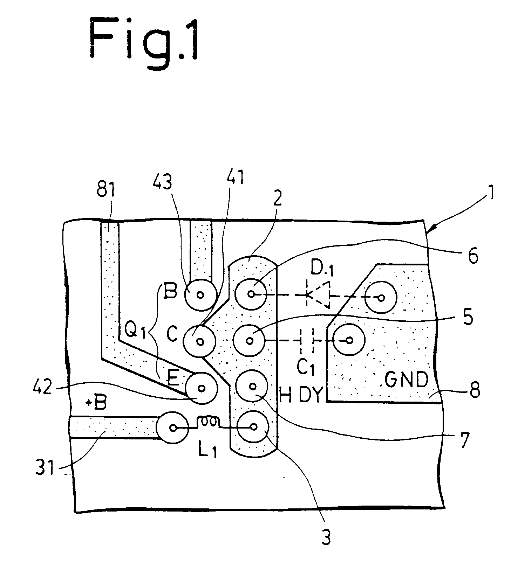

As shown in Figure 1, this embodiment, the centralized land 2 is disposed on one side of an insulation substrate 1, and the power output terminal 3 and circuit terminals to be connected with the power output terminal 3 are connected on the centralized land 2. This embodiment has a connection substrate structure in a printed substrate in which a printed pattern is formed with copper on a substrate made of a synthetic resin.

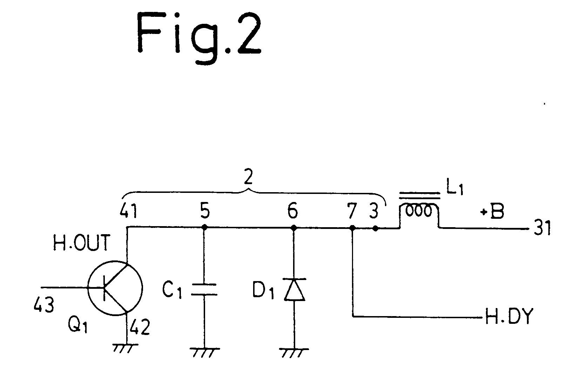

More specifically, this embodiment concerns a structure for a circuit connection substrate used for a horizontal deflection output circuit disposed on the insulating substrate 1. As shown in Figure 1 and the corresponding circuit diagram of Figure 2 a transistor Q₁, a capacitor C₁ and a diode D₁ are disposed on one side of the substrate 1, while the centralized land 2 is disposed on the other side of the substrate 1 in which each of connection terminals 5, 6, 7 for the power output terminal 3, the collector terminal 41 of the transistor Q₁, the capacitor C₁, the diode D₁, and a horizontal deflection yoke (H, DY) are connected on the centralized land 2.

In Figure 1, are shown a coil L₁, a connection pattern 31 of a power source B⁺, an emitter terminal 42 for the transistor Q₁, a base terminal 43 for the transistor Q₁, a grounding land 8 for grounding to the earth, and a pattern 81 for connecting the emitter E of the transistor Q₁ to the earth. In Figure 2, reference numerals 2, 3, 31, 41, 42, 43, 5, 6, and 7 denote, respectively, corresponding portions in Figure 1.

In Figure 1, a lead wire is soldered to the horizontal deflection yoke connection terminal 7 to establish an electric connection.

In this embodiment, large currents and high voltages are applied to the collector. For example, a current of 2A and a voltage of about 200 V in the peak are applied. With the constitution of this embodiment, pattern disconnection or the like is not caused so that heat generation, smoke and ignition are prevented, and a highly reliable device is provided.

The illustrated connection portion integrated by disposing the centralized land 2 as in this embodiment is confined within a square of 10 mm side. Further, it is confined within a size of about 30 mm square at the opposite side thereof and on which the parts are mounted. This is a sufficient mounting density and can prevent the problems caused by large currents and high voltages.

As has been described above according to the present invention, reliability of such a substrate can be improved when it is applied to a connection structure of a circuit used under high voltage and large current. The line pattern can be reduced in usual applications, thereby improving the reliability by minimizing heat generation in the portion in which a large current is supplied.

## Claims

1. A structure for a circuit connection substrate having a connection pattern for electric circuits and a power source on one side or both sides of an insulating substrate (1), wherein
a centralized land (2) is disposed on one side of said insulating substrate (1), and
the power source output terminal (3) and the electric circuit terminals (5-7, 41) to be connected with said power source output terminal are connected on said centralized land.

2. A structure for a circuit connection substrate used for a horizontal deflection output circuit disposed on an insulation substrate (1), wherein
a transistor (Q₁), a capacitor (C₁) and a diode (D₁) are disposed on one side of said substrate,
a connection pattern (31) of a power source is disposed on the other side of the substrate,
a centralized land (2) is disposed on the other side of said substrate, and
the power source output terminal (3), the collector terminal (41) for the transistor, and each of the connection terminals (5-7) to the capacitor (C₁), the diode (D₁) and a horizontal deflection yoke (HDY) are connected on said centralized land (2).

3. A structure for a circuit connection substrate (1) as defined in claim 2, wherein the horizontal deflection output circuit is a horizontal deflection output circuit in a television receiver.

4. A structure for a circuit connection substrate (1) as defined in any one of claims 1 to 3, which is applied as a structure for a connection substrate in a printed substrate and in which a printed pattern is formed with metal on the substrate made of a synthetic resin.

## Patentansprüche

1. Struktur für ein Schaltungssubstrat, das auf einer Seite oder auf beiden Seiten eines isolierenden Substrats (1) ein Schaltungsmuster für elektrische Schaltkreise und eine Stromversorgungsschaltung aufweist, wobei
auf einer Seite des isolierenden Substrats (1) eine zentrale Kontaktierungsfläche (2) vorgesehen ist und
der Ausgangsanschluß (3) der Stromversorgungsschaltung und die mit dem Ausgangsanschluß (3) der Stromversorgungsschaltung zu verbindenden Anschlüsse (5 -7) der elektrischen Schaltkreise mit dieser zentralen Kontaktierungsfläche verbunden sind.

2. Struktur für ein Schaltungssubstrat, das für eine Zeilenablenk-Ausgangsstufe verwendet wird, die auf einem isolierenden Substrat (1) angeordnet ist, wobei
ein Transistor (Q₁), ein Kondensator (C1) und eine Diode (D₁) auf einer Seite des Substrats (1) angeordnet sind,
ein Verbindungsmuster (31) einer Stromversorgungsschaltung auf der anderen Seite des Substrats angeordnet ist,
eine zentrale Kontaktierungsfläche (2) auf der anderen Seite des Substrats angeordnet ist und
der Ausgangsanschluß (3) der Stromversorgungsschaltung, der Kollektoranschluß (41) für den Transistor und die jeweiligen Verbindungsanschlüsse (5 - 7) zu dem Kondensator (C₁), der Diode (D₁) und einem Zeilenablenkjoch (HDY) mit der zentralen Kontaktierungsfläche (2) verbunden sind.

3. Struktur für ein Schaltungssubstrat nach Anspruch 2, bei der die Zeilenablenk-Ausgangsstufe die Zeilenablenk-Ausgangsstufe eines Fernsehempfängers ist.

4. Struktur für ein Schaltungssubstrat nach einem der Ansprüche 1 bis 3, die als eine Struktur für ein Verbindungssubstrat in einem gedruckten Substrat angewendet sird und in der ein gedrucktes Muster aus Metall auf einem Substrat aus Kunstharz ausgebildet ist.

## Revendications

1. Structure pour substrat de connexion de circuit possédant un motif de connexion destiné à des circuits électriques et une source d'alimentation électrique sur une face ou sur les deux faces d'un substrat isolant (1), où :
une plage de connexion centralisée (2) est disposée sur une face dudit substrat isolant (1), et
la borne de sortie (3) de la source d'alimentation électrique et les bornes (5 à 7, 41) des circuits électriques devant être connectées à ladite borne de sortie de la source d'alimentation électrique sont connectées sur ladite plage de connexion centralisée.

2. Structure pour substrat de connexion de circuit, utilisée pour un circuit de sortie de déviation horizontale disposé sur un substrat d'isolation (1), où :
un transistor (Q₁), un condensateur (C₁) et une diode (D₁) sont disposés sur une face dudit substrat,
un motif de connexion (31) d'une source d'alimentation électrique est disposé sur l'autre face dudit substrat,
une plage de connexion centralisée (2) est disposée sur l'autre face dudit substrat, et
la borne de sortie (3) de la source d'alimentation électrique, la borne de collecteur (41) du transistor, et chacune des bornes de connexion (5 à 7) du condensateur (C₁), de la diode (D₁) et d'un bloc de déviation horizontale (HDY) est connectée sur ladite plage de connexion centralisée (2).

3. Structure pour substrat de connexion de circuit (1) selon la revendication 2, où le circuit de sortie de déviation horizontale est un circuit de sortie de déviation horizontale d'un récepteur de télévision.

4. Structure pour substrat de connexion de circuit (1) selon l'une quelconque des revendications 1 à 3, qui est appliquée comme structure pour substrat de connexion dans un substrat imprimé et dans laquelle un motif imprimé est formé à l'aide de métal sur le substrat fait d'une résine synthétique.
